Europäisches Patentamt

European Patent Office

Office européen des brevets

(11) Publication number: **0 464 447 A1**

# EUROPEAN PATENT APPLICATION

(21) Application number: **91109925.7**

(22) Date of filing: **18.06.91**

(51) Int. Cl.5: **C23C 16/32**, C23C 16/02, C04B 35/56

(30) Priority: **02.07.90 JP 174845/90**

(43) Date of publication of application:
**08.01.92 Bulletin 92/02**

(84) Designated Contracting States:
**DE FR GB IT**

(71) Applicant: **TOSHIBA CERAMICS CO., LTD.**
**26-2, 1-chome, Nishi-shinjuku**
**Shinjuku-ku Tokyo(JP)**

(72) Inventor: **Nozawa, Tatso, Oguni Plant**
**378 Ohaza-Ogunimachi, Oguni-machi**
**Nishi-Okitama-gun, Yamagata-ken(JP)**
Inventor: **Tabei, Takahiro, Oguni Plant**
**378 Ohaza-Ogunimachi, Oguni-machi**
**Nishi-Okirama-gun, Yamagata-ken(JP)**

(74) Representative: **Witte, Alexander, Dr.-Ing. et al**
**Augustenstrasse 7**
**W-7000 Stuttgart 1(DE)**

(54) A SiC component and a method for making the same.

(57) A SiC component is impregnated with Si and has a CVD coating (3). A SiC base material (1) is impregnated with Si. A Si-removed layer (2) is formed in the range of from 2 % to 15 % in the thickness direction from the surface of the SiC base material (1) in which the impregnated Si is removed from the SiC base material. A SiC coating (3) is formed on the Si-removed layer (2) by a CVD method.

FIG.1

BACKGROUND OF THE INVENTION

This invention relates to a SiC component impregnated with Si and having a CVD coating and a method for making the same.

In the semiconductor industry, a SiC component impregnated with Si is used as a tube, a boat and other similar tools for the purpose of heat treatment such as oxidation or diffusion of semiconductor wafers such as Si wafers.

A high purity of SiC components impregnated with Si have been desired in particular in view of large semiconductor wafers and the trend toward LSI.

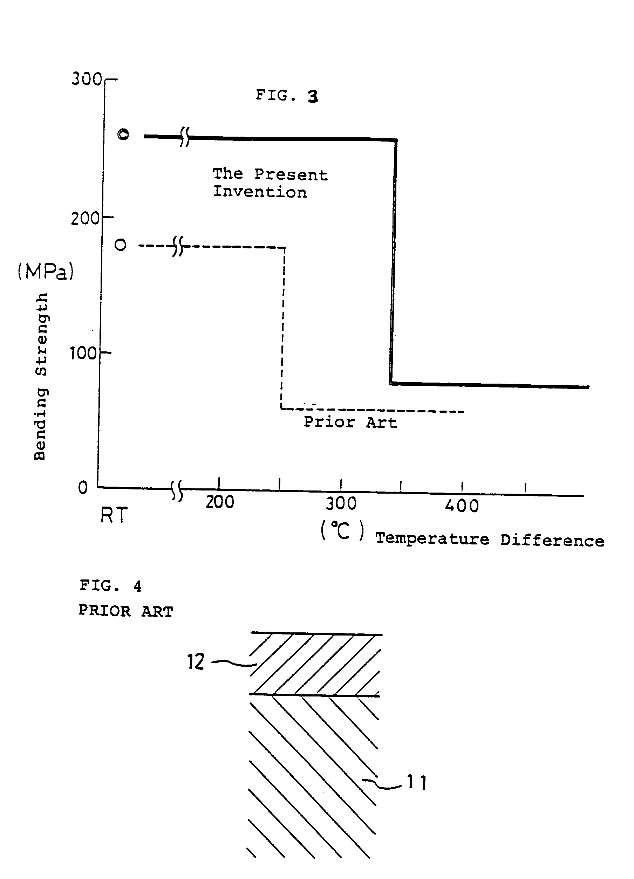

As shown in Fig. 4, a standard SiC component impregnated with Si and having a CVD coating is produced by impregnating a SiC base material 11 with Si and then forming a SiC coating 12 on the SiC base material 11 by a CVD method.

However, in the conventional SiC components impregnated with Si and having a CVD coating, the step of forming a CVD coating made of SiC is carried out at a temperature of at least several hundreds degree Celsius. The CVD coating made of SiC has a thermal expansion coefficient which is larger than the thermal expansion coefficient ($4.5 \times 10^{-6}$/$^{\circ}$C) of the SiC base material containing Si of from several percent to 20 % by weight. The difference in the thermal expansion coefficient of them is about 5 percent. Therefore, after the coating step is carried out, when the component is cooled, the contraction coefficient of the CVD-SiC coating is larger than that of the base material.

Therefore, a tensile stress corresponding to the contraction is applied onto the CVD-SiC coating. In case the component is a tube or boat, it is deflected due to the weight of things to be treated on the component. As a result, micro cracking is apt to be formed in a surface portion of the component and particulary in the CVD-SiC coating. If the component is repeatedly used in such a condition, the cracking reaches into the SiC base material impregnated with Si so that the whole of the component is finally broken.

SUMMARY OF THE INVENTION

The object of the present invention is to provide a SiC component impregnated with Si and having a CVD coating and a method for making the same in which thermal shock resistance and bending strength are excellent.

In order to achieve the object of the present invention, a SiC component impregnated with Si and having a CVD coating according to the present invention has a Si-removed layer and a SiC coating formed on the Si-removed layer by a CVD method. The Si-removed layer is made by impregnating the base material with Si and thereafter removing the impregnated Si in the SiC base material in the range of from 2 % to 15 % of the thickness of the SiC base material from the surface thereof in its thickness direction.

A method for making a SiC component impregnated with Si and having a CVD coating according to the present invention includes the steps of removing the impregnated-Si in the SiC base material in the range of 2 % through 15 % of the thickness of the base material from its surface thereby to form a Si-removed layer, and forming a SiC coating on the Si-removed layer by a CVD method. Prior to the Si removing step, the SiC base material is impregnated with Si. After the Si impregnating step, halogen gas or hydrogen halide gas flows along and on the SiC base material at a temperature of at least 800 $^{\circ}$C. Otherwise, the SiC base material impregnated with Si can be immersed into a fluoric nitrate solution. As a result, the impregnated Si in the SiC base material is removed in the range of 2 % through 15 % of the thickness of the base material from its surface in its thickness direction.

It is preferable to remove the impregnated-Si by a dry treatment method using gas although both of dry and wet methods can be employed.

In case of the wet treatment method, some liquid remains in the Si-removed layer while the CVD-SiC coating is formed on the Si-removed layer. In such a case, the liquid is closed in the Si-removed layer by the CVD-SiC coating. If the Si-removed layer is heated at a high temperature, the volume of the liquid suddenly increases so that the CVD-SiC coating and/or the base material may be broken.

Even in case of the wet treatment method, the remaining liquid can be removed from the Si-removed layer. For example, it is heated in a vacume condition at a temperature of 1,000 $^{\circ}$C for at least several hours. After that, inert gas flows on the Si-removed layer while it is cooled to a room temperature, so that the remaining liquid can be completely removed so as to obtain substantially the same results as those of the dry treatment method.

According to the present invention, the Si-removed layer has a thermal expansion coefficient which is positioned between that of the CVD-SiC coating and that of the SiC base material impregnated with Si. Therefore, the difference in the tensile stress between the CVD-SiC coating and the SiC base material impregnated with Si is relaxed at a high temperature.

If the thickness of the Si-removed layer is less than 2 % of the thickness of the base material from the surface thereof, the heat shock resistnace of the CVD-SiC coating is relatively low. If the thickness of the Si-removed layer is more than 15 % of the thickness of the base material from the surface thereof, the bending strength of the component is decreased because the total thickness of the two Si-removed layers at both front and back sides of the component becomes more than 30 %.

BRIEF DESCRIPTION OF THE DRAWINGS

Fig. 1 is an explanation view showing a SiC component impregnated with Si and having a CVD coating according to a preferred embodiment of the present invention;
Fig. 2 is an explanation view showing relationships between the Si-removed layer and bending strength;
Fig. 3 is an explanation view showing relationships between temperature difference and bending strength according to samples of the present invention and the prior art samples; and
Fig. 4 is a schematic view showing an essential portion of a conventional SiC component impregnated with Si and having a CVD coating.

DETAILED DESCRIPTION OF THE EMBODIMENTS

A preferred embodiment of the present invention will be explained in detail referring to the drawings.

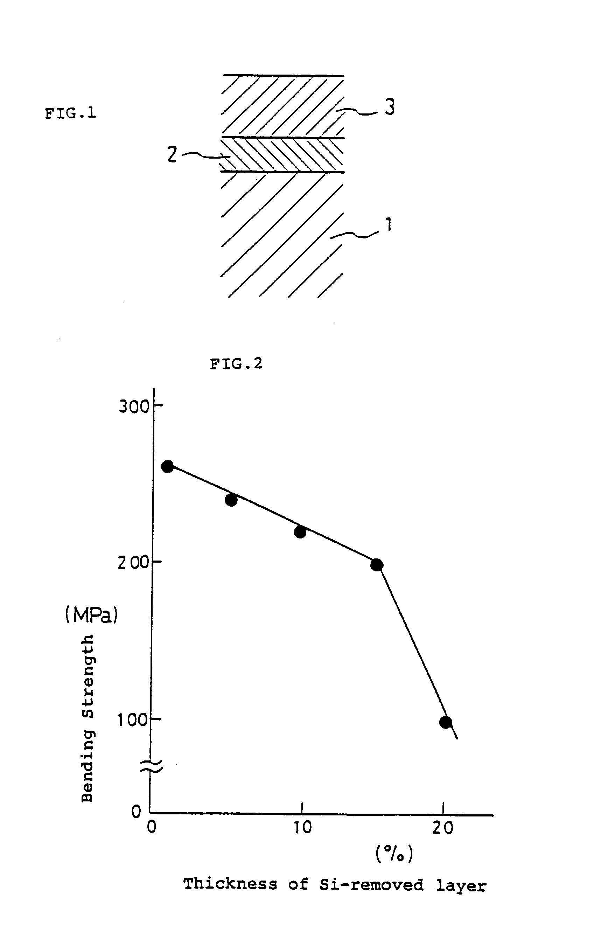

Fig. 1 is a schematic view showing an essential portion of a SiC component impregnated with Si and having a CVD coating according to a preferred embodiment of the present invention.
The reference 1 designates a SiC base material impregnated with Si. A Si-removed layer 2 is formed in the range of from 2 % to 15 % of the thickness of the base material 1 in the thickness direction from the surface thereof. A CVD-SiC coating 3 is formed on the Si-removed layer 2 by a CVD method.
A method for making such a SiC component impregnated with Si and having a CVD coating is explained as follows.
For example, a SiC base material impregnated with Si has a size of 3 x 4 x 50 mm in the shape of a rectangular parallelopiped. The SiC base material is placed at a temperature of 900 °C wihtin a reaction furnace. In such a condition, halogen gas flows into the reaction furnace. The flow rate changes. As shown in Fig. 1, the impregnated Si is removed in the range of about 100 microns in the thickness direction from the surface of the SiC base material 1 so as to form a Si-removed layer 2.
By the same method, various SiC base materials impregnated with Si are produced. The base material 1 has the Si-removed layer 2.
These SiC base materials are heated at a temperature of 1,300 °C within the reaction furnace in which the reaction gas including $SiCl_4$ and $C_3H_8$ gases and the carrier gas including $H_2$ gas flows in the reaction furnace whereby the CVD-SiC layer 3 is formed on the Si-removed layer 2 until it has the coating thickness of 100 microns. By the same method, various test pieces are produced.
According to the test results of those test pieces, the relationships between the thickness of the Si-removed layer and the bending strength are shown in Fig. 2. In Fig. 2, the zero percent thickness of the Si-removed layer designates a prior art sample or test piece.
If the thickness of the Si-removed layer is more than 15 %, the total thickness of the two Si-removed layers at both front and back sides of the base material is more than 30 %, and the bending strength of the component rapidly decreases. This is because, if the tensile stress is applied onto the coating, cracking takes place and develops rapidly from some defect portions thereof.
Table 1 and Fig. 3 show the bending strength in average and the thermal shock resistance of the samples of both the present invention and the prior art. In the samples of the present invention, the Si-removed layer has a thickness corresponding to 2 % of the thickness of the base material and the CVD-SiC component has a thickness of 100 microns. In the samples of the prior art, the CVD-SiC coating has a thickness of 95 microns.

3

Table 1

| | bending strength (MPa) | standard deviation | thermal shock resistance $\Delta$ Tc($^{\circ}$C) |
|---|---|---|---|
| samples of the present invention | 245 | 25 | 350 |
| samples of the prior art | 175 | 40 | 250 |

Accordingly, if the thickness of the Si-removed layer is less than 2 % of the thickness of the base material, it can be observed that the thermal shock resistance decreases.

According to the present invention, as the thermal expansion coefficient of the Si-removed layer is positioned between that of the CVD-SiC coating and that of the SiC base material impregnated with Si, the stress due to the thermal expansion differences between the CVD-SiC coating and the SiC base material impregnated with Si can be relaxed so that the micro cracking in the CVD-SiC coating can be prevented from taking place. As a result, a SiC component impregnated with Si and having a CVD coating can have excellent improved thermal shock resistance and bending strength according to the present invention.

**Claims**

1. A SiC component impregnated with Si and having a CVD coating, comprising a SiC base material (1) impregnated with Si, and the coating (3) being formed on the SiC base material, characterized in that a Si-removed layer (2) is formed in the base material (1), and the SiC coating (3) is formed on the Si-removed layer (2), so as to close the Si-removed layer (2).

2. The SiC component of claim 1, characterized in that the Si-removed layer (2) is formed in the range of from 2 % to 15 % of the thickness of the base material (1) in its thickness direction from the surface thereof.

3. The SiC component of claim 1 or 2, characterized in that the SiC coating (3) is formed on the Si-removed layer (2) by a CVD method.

4. The SiC component of any one of claims 1 - 3, characterized in that the Si-removed layer (2) is formed by removing the impregnated Si from the SiC base material (1).

5. A method for making a SiC component impregnated with Si in which a SiC coating (3) is formed on a SiC base material (1), characterized by
   - removing the impregnated Si from the SiC base material (1) in the range of from 2 % to 15 % of

4

the thickness of the base material in the thickness direction of the SiC base material (1) from the surface thereof, thereby to form a Si-removed layer (2),

- and thereafter forming the SiC coating (3) on the SiC base material, so as to close the Si-removed layer (2).

6. The method of claim 5, characterized in that the SiC coating (3) is formed on the Si-removed layer (2) by a CVD method.

7. The method of claims 5 or 6, characterized in that the step of removing the impregnated Si includes applying halogen gas or hydrogen halide gas on the SiC base material (1) impregnated with Si at a temperature of at least 800 ˚C.

8. The method of claims 5 or 6, characterized in that the step of removing the impregnated Si includes immersing the SiC material (2) into a fluoric nitrate solution.

FIG.1

FIG.2

Thickness of Si-removed layer

FIG. **3**

The Present
Invention

Prior Art

Bending Strength (MPa)

Temperature Difference (°C)

RT  200  300  400

0  100  200  300

FIG. 4

PRIOR ART

12

11

European
Patent Office

EUROPEAN SEARCH
REPORT

Application Number

EP 91 10 9925

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DE-A-3 701 691 (TOSHIBA CERAMICS) <br> * claim 1 * <br> — — — | 1-8 | C 23 C 16/32 <br> C 23 C 16/02 <br> C 04 B 35/56 |
| A | PATENT ABSTRACTS OF JAPAN vol. 13, no. 501 (C-652)(3849) November 10, 1989 <br> & JP-A-1 201 087 (EAGLE IND. CO. ) August 14, 1989 <br> * the whole document * <br> — — — — — | 8 | |

TECHNICAL FIELDS
SEARCHED (Int. Cl.5)

C 23 C
C 04 B

The present search report has been drawn up for all claims

| Place of search | Date of completion of search | Examiner |
|---|---|---|
| The Hague | 07 October 91 | PATTERSON A.M. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

 

& : member of the same patent family, corresponding document